# FASCICULE DE BREVET EUROPEEN

(11) **EP 4 465 533 B1**
(45) Date de publication et mention de la délivrance du brevet: **01.04.2026**
(21) Numéro de dépôt: 24175528.9
(22) Date de dépôt: 13.05.2024
(51) Int. Cl.: H03B 5/12, H03B 27/00

(54) **OSCILLATEURS EN QUADRATURE**
QUADRATUROSZILLATOREN
QUADRATURE OSCILLATORS

(30) Priorité: 15.05.2023 FR 2304792
(43) Date de publication de la demande: 20.11.2024
(73) Titulaire: STMicroelectronics International N.V., 1228 Plan-les-Ouates, Geneva (CH)
(72) Inventeur: GIRY-CASSAN, Florence, 38700 CORENC (FR); RANIERI, Antoine, 38330 MONTBONNOT-SAINT-MARTIN (FR)
(74) Mandataire: Cabinet Beaumont

(56) Documents cités:
- CN-B- 114 978 042
- US-A1- 2006 091 969
- US-B2- 7 421 052

## Description

### Domaine technique

La présente description concerne de façon générale les circuits électroniques, par exemple les circuits électroniques intégrés, et, plus particulièrement, dans ces circuits électroniques, les dispositifs pour générer deux signaux radiofréquences périodiques en quadrature l'un par rapport à l'autre.

### Technique antérieure

De nombreux circuits électroniques connus, par exemple les émetteurs et/ou récepteur sans fil, comprennent des dispositifs connus pour générer des signaux périodiques en quadrature l'un par rapport à l'autre.

Certains de ces dispositifs connus utilisent un filtre polyphase pour générer les deux signaux en quadrature.

D'autres dispositifs connus utilisent un oscillateur fournissant un premier signal périodique à partir duquel sont généré les deux signaux en quadrature par une division de fréquence, le premier signal devant alors avoir une fréquence deux fois plus élevée que celle visée pour les deux signaux en quadrature.

Encore d'autres dispositifs connus utilisent deux oscillateurs interconnectés l'un à l'autre de sorte à fournir les deux signaux en quadrature, ces deux oscillateurs interconnectés étant dit en quadrature. Un exemple d'un tel dispositif à oscillateurs en quadrature est par exemple décrit en relation avec la figure numérotée 1(b) de l'article "A 900MHz CMOS LC-Oscillator with Quadrature Outputs" de A. Rofougaran et. al, publié en 1996 dans ISSCC.

Toutefois, les dispositifs connus décrits ci-dessus présentent des inconvénients. Par exemple, ces dispositifs connus ne permettent pas l'obtention de signaux en quadrature dont la fréquence est sélectionnable (ou réglable) parmi plusieurs valeurs élevées, par exemple supérieures à 5 GHz, s'étendant sur une large plage de fréquences, par exemple une plage de fréquence allant de 5 à 10 GHz. Par exemple, ces dispositifs connus ne sont pas adaptés à une mise en œuvre dans un circuit d'émission et/ou de réception radiofréquence Ultra Large Bande (UWB de l'anglais "Ultra Wide Band").

US7421052B2 divulgue un système avec deux oscillateurs couplés. CN114978042 B divulgue des oscillateurs LC non-couplés avec un facteur de qualité de l'inductance inférieur au facteur de qualité de la capacité. US2006/091969 A1 divulgue la réduction du facteur de qualité d'un résonateur LC d'un oscillateur individuel.

### Résumé de l'invention

Il existe un besoin de pallier tout ou partie des inconvénients des dispositifs connus pour générer deux signaux en quadrature.

Par exemple, il existe un besoin pour un dispositif permettant de générer deux signaux en quadrature avec une fréquence dont la valeur est supérieure à 5 GHz et sélectionnable sur une large bande de fréquences allant par exemple de 5 GHz à 10 GHz.

Un mode de réalisation pallie tout ou partie des inconvénients des dispositifs connus pour générer deux signaux en quadrature.

Un mode de réalisation prévoit un dispositif comprenant deux oscillateurs couplés l'un à l'autre de sorte à fonctionner en quadrature, chaque oscillateur comprenant une inductance et une capacité à valeur sélectionnable parmi au moins deux valeurs correspondant chacune à une valeur de fréquence de fonctionnement des oscillateurs, chaque oscillateur étant configuré pour que, pour chaque valeur de fréquence de fonctionnement des oscillateurs, le facteur de qualité de son inductance soit inférieur au facteur de qualité de sa capacité.

Selon un mode de réalisation, dans chaque oscillateur :
l'inductance comprend des premier et deuxième enroulements identiques ;
le premier enroulement a une première extrémité couplée à un premier noeud d'application d'un potentiel d'alimentation et
une deuxième extrémité couplée à un deuxième noeud de sortie de l'oscillateur ;
le deuxième enroulement a une première extrémité couplée au premier noeud et une deuxième extrémité couplée à un troisième noeud de sortie de l'oscillateur ; et
une première électrode de la capacité est connectée au deuxième noeud et une deuxième électrode de la capacité est connectée au troisième noeud.

Selon un mode de réalisation, dans chaque oscillateur, l'inductance comprend une première résistance connectée en série avec le premier enroulement entre les premier et deuxième noeuds, et une deuxième résistance connectée en série avec le deuxième enroulement entre les premier et troisième noeuds, les première et deuxième résistances ayant une même valeur de résistance.

Selon un mode de réalisation, chacune des première et deuxième résistances a une valeur de résistance comprise entre 0,5 et 5 ohms, lesdites au moins deux valeurs de la capacité étant par exemple comprises entre 0,5 et 2,0 pF et l'inductance ayant par exemple une valeur comprise entre 300 et 700 pH.

Selon un mode de réalisation, dans chaque oscillateur, chacune des première et deuxième résistances est mise en œuvre par au moins une portion de silicium polycristallin, de préférence non dopé.

Selon un mode de réalisation, chacune des première et deuxième résistances comprend :
une première portion conductrice d'un premier niveau de métal d'une structure d'interconnexion, la première portion conductrice correspondant à une première borne de la résistance ;
une deuxième portion conductrice du premier niveau de métal correspondant à une deuxième borne de la résistance ;
au moins une troisième portion conductrice d'un deuxième niveau de métal de la structure d'interconnexion ;
au moins une quatrième portion conductrice du deuxième niveau de métal ;
des premiers vias conducteurs couplant électriquement la première portion à ladite au moins une troisième portion et
la deuxième portion à ladite au moins une quatrième portion ; et
des deuxièmes vias conducteurs couplant électriquement ladite au moins une portion de silicium polycristallin à ladite au moins une troisième portion et à ladite au moins une quatrième portion.

Selon un mode de réalisation, dans chacun des oscillateurs, la capacité comprend une pluralité de capacités associées à des interrupteurs configurés pour que chacune des au moins deux valeurs corresponde à une combinaison donnée d'états ouvert et fermé desdits interrupteurs.

Selon un mode de réalisation, dans chacun des oscillateurs, la capacité à valeur sélectionnable comprend en outre des diodes varicap.

Selon un mode de réalisation, chacun des oscillateurs comprend en outre :
un premier transistor MOS et un deuxième transistor MOS ayant chacun une première borne de conduction connectée au deuxième noeud et une deuxième borne de conduction couplée à un cinquième noeud d'application d'un potentiel de référence, le premier transistor ayant sa grille couplée au troisième noeud ;
un troisième transistor MOS et un quatrième transistor MOS ayant chacun une première borne de conduction connectée au troisième noeud et une deuxième borne de conduction couplée au cinquième noeud, le troisième transistor ayant sa grille couplée au deuxième noeud.

Selon un mode de réalisation :
le deuxième transistor d'un premier des deux oscillateurs a sa grille couplée au deuxième noeud d'un deuxième des deux oscillateurs ;
le quatrième transistor du premier oscillateur a sa grille couplée au troisième noeud du deuxième oscillateur ;
le deuxième transistor du deuxième oscillateur a sa grille couplée au troisième noeud du premier oscillateur ; et
le quatrième transistor du deuxième oscillateur a sa grille couplée au deuxième noeud du premier oscillateur.

Selon un mode de réalisation, chacun des oscillateurs comprend :
une première source de courant ayant une première borne connectée aux deuxièmes bornes de conduction des premier et
troisième transistors de l'oscillateur, et une deuxième borne connectée au cinquième noeud ; et
une deuxième source de courant ayant une première borne connectée aux deuxièmes bornes de conduction des deuxième et
quatrième transistors de l'oscillateur, et une deuxième borne connectée au cinquième noeud.

Selon un mode de réalisation, chaque valeur de fréquence de fonctionnement appartient à une plage allant de 5 GHz à 10 GHz.

Selon un mode de réalisation, les valeurs de fréquence de fonctionnement comprennent une première valeur comprise entre 5 et 6,5 GHz et une deuxième valeur comprise entre 8,5 et 10 GHz.

Selon un mode de réalisation, chacune des valeurs de fréquence de fonctionnement est séparée des autres valeurs de fréquence de fonctionnement par au moins 0,5 GHz.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un mode de réalisation d'un oscillateur ;

la figure 2 représente sous la forme de blocs un mode de réalisation d'un dispositif comprenant deux oscillateurs en quadrature identiques à celui de la figure 1 ;

la figure 3 représente, par une vue de dessus schématique, un exemple d'un mode de réalisation d'une résistance des oscillateurs des figures 1 et 2 ;

la figure 4 représente une vue en coupe schématique de la résistance de la figure 3.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques usuels, par exemple intégrés, et les applications usuelles dans lesquels peut être prévu un dispositif pour générer deux signaux en quadrature n'ont pas été détaillé, les modes de réalisation décrits étant compatibles avec ces circuits et applications usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf indication contraire, la valeur d'un paramètre est dite sélectionnable parmi plusieurs valeurs lorsque la valeur du paramètre est commandable et peut prendre chacune desdites plusieurs valeurs en fonction de sa commande. Par exemple, la valeur d'une capacité est dite sélectionnable parmi plusieurs valeurs lorsque la capacité peut prendre chacune de ces plusieurs valeurs, par exemple sous le contrôle d'un ou plusieurs signaux de commande. A titre d'autre exemple, la valeur d'une fréquence de fonctionnement est dite sélectionnable parmi plusieurs valeurs lorsque la fréquence peut prendre chacune de ces plusieurs valeurs, par exemple sous le contrôle d'un ou plusieurs signaux de commande.

Sauf précision contraire, les expressions "environ", "approximativement", "sensiblement", et "de l'ordre de" signifient à 10 % près, de préférence à 5 % près.

Parmi les dispositifs connus présentés précédemment, les oscillateurs en quadrature permettent de générer des signaux en quadrature ayant des fréquences supérieures au GHz, par exemple une fréquence de l'ordre de 5 GHz. Toutefois, les oscillateurs en quadrature peuvent commuter entre deux modes de fonctionnement correspondant respectivement à deux valeurs de fréquences différentes pour les signaux en quadrature générés par le dispositif. Plus particulièrement, dans un premier des deux modes de fonctionnement, la fréquence de fonctionnement des oscillateurs en quadrature est supérieure à la fréquence de fonctionnement de ces oscillateurs non interconnectés l'un à l'autre, et, dans un deuxième des deux modes de fonctionnement, la fréquence de fonctionnement des oscillateurs en quadrature est inférieure à la fréquence de fonctionnement de ces oscillateurs non interconnectés l'un à l'autre. Forcer les oscillateurs du dispositif à fonctionner dans l'un des deux modes uniquement permet d'assurer que la fréquence des signaux en quadrature est bien celle désirée. Pour cela, il a été proposé d'ajouter des déphaseurs dans les connexions entre les deux oscillateurs en quadrature. Toutefois, dans un dispositif à oscillateurs en quadrature interconnectés l'un à l'autre par l'intermédiaire de déphaseurs, les déphaseurs sont dimensionnés pour une fréquence donnée de fonctionnement, c'est à dire une fréquence donnée des signaux en quadrature fournis par le dispositif. Il en résulte que la commutation entre les deux modes de fonctionnement n'est pas maitrisée sur toute la plage de fonctionnement du dispositif ce qui pose problème. Par exemple, un tel dispositif n'est pas adapté à générer des signaux en quadrature ayant une fréquence dont la valeur est sélectionnable parmi plusieurs valeurs comprises dans une plage allant de 5 GHz à 10 GHz, par exemple une fréquence dont la valeur est sélectionnable parmi au moins une première valeur de fréquence comprise entre 5 et 6,5 GHz et une deuxième valeur de fréquence comprise entre 8,5 et 10 GHz et/ou une fréquence dont la valeur est sélectionnable parmi plusieurs valeurs séparées les unes des autres d'au moins 0,5 GHz.

Il est ici proposé un dispositif comprenant deux oscillateurs en quadrature, c'est à dire deux oscillateurs couplés l'un à l'autre de sorte à fonctionner en quadrature, dans lequel chaque oscillateur comprend une charge ("tank" en anglais) de type LC en parallèle et est configuré pour que, à chaque valeur sélectionnable de fréquence de fonctionnement des oscillateurs du dispositif, le facteur de qualité de l'inductance L de la charge LC soit plus faible que le facteur de qualité de la capacité C de la charge LC. En pratique, dans un tel dispositif, la charge LC comprend une capacité ayant une valeur sélectionnable (ou commandable) parmi plusieurs valeurs, chacune de ces valeurs sélectionnables de capacité correspondant à une fréquence de fonctionnement différente du dispositif.

La prévision d'une inductance L avec un facteur de qualité plus faible que celui de la capacité C conduit à des pertes plus importantes par rapport au cas où l'inductance L aurait un facteur de qualité plus élevé, par exemple plus élevé que celui de la capacité C. Cela va à l'encontre des pratiques usuelles qui consistent, dans la charge LC d'un oscillateur, à avoir une inductance L dont le facteur de qualité est aussi élevé que possible et donc généralement plus élevé que celui de la capacité C de la charge LC. En effet, une charge LC ayant une inductance L avec un facteur de qualité le plus élevé possible, et, en particulier, plus élevé que celui de la capacité C de la charge, permet de limiter la consommation et d'optimiser (par exemple réduire) le bruit de phase.

Cependant, la prévision, pour chaque valeur sélectionnable de fréquence de fonctionnement du dispositif, d'une inductance L avec un facteur de qualité plus faible que celui de la capacité permet que, pour chacune de ces valeurs de fréquence de fonctionnement, le dispositif soit toujours dans le même mode de fonctionnement parmi les deux modes de fonctionnements entre lesquels des oscillateurs en quadrature peuvent commuter.

Afin d'assurer que, pour chaque valeur sélectionnable de fréquence de fonctionnement du dispositif, le dispositif soit toujours dans le même mode de fonctionnement parmi les deux modes de fonctionnements entre lesquels des oscillateurs en quadrature peuvent commuter, on aurait pu penser à configurer la charge LC de sorte que, à chaque valeur sélectionnable de fréquence de fonctionnement, le facteur de qualité de l'inductance L de la charge LC soit plus élevé que le facteur de qualité de la capacité C de la charge LC. Toutefois, le dispositif serait alors maintenu dans le mode de fonctionnement où la fréquence des signaux en quadrature qu'il fournit est plus faible que la fréquence de fonctionnement de chacun des oscillateurs non interconnectés l'un à l'autre. A l'inverse, quand pour chaque valeur sélectionnable de fréquence de fonctionnement du dispositif, le facteur de qualité de l'inductance L de la charge LC est plus faible que le facteur de qualité de la capacité C de la charge LC, le dispositif est maintenu dans le mode de fonctionnement où la fréquence des signaux en quadrature qu'il fournit est plus élevée que la fréquence de fonctionnement des oscillateurs non interconnectés l'un à l'autre, ce qui est avantageux lorsque l'on vise des fréquences de fonctionnement supérieures à 5 GHz comprenant par exemple une fréquence de fonctionnement comprise entre 8,5 et 10 GHz.

Selon un mode de réalisation, pour assurer que, pour chaque valeur sélectionnable de fréquence de fonctionnement, le facteur de qualité de l'inductance L est plus faible que celui de la capacité C, l'inductance L de chaque oscillateur comprend au moins une résistance, malgré que cette résistance augmente les pertes dans l'inductance. A titre d'exemple, cette résistance est configurée pour limiter l'augmentation de la consommation, du bruit de phase et des capacités résultant de l'introduction de cette résistance, tout en assurant que, pour chacune des valeurs sélectionnables de fréquence de fonctionnement du dispositif, le dispositif soit maintenu dans le même mode de fonctionnement, à savoir celui où le facteur de qualité de l'inductance est plus faible que celui de la capacité. De préférence, la valeur de la résistance est choisie la plus petite possible parmi les valeurs de résistance permettant d'assurer le fonctionnement ci-dessus.

Selon un mode de réalisation, l'au moins une résistance de l'inductance L est mise en œuvre par une portion de silicium polycristallin intrinsèque (c'est à dire non dopé intentionnellement), plutôt que par une portion conductrice d'un niveau de métal d'une structure d'interconnexion du circuit intégré du dispositif. En effet, le silicium polycristallin ne souffre pas des problèmes d'électromigration dont souffre une portion de couche métallique d'un niveau de métal.

Des modes de réalisation et variantes d'un tel dispositif vont maintenant être décrits.

Dans la suite de la description, à titre d'exemple, le dispositif décrit est configuré pour avoir une fréquence de fonctionnement dont la valeur est sélectionnable parmi au moins deux valeurs appartenant à une plage de fréquences allant de 5 GHz à 10 GHz, par exemple parmi au moins deux valeurs comprenant une première valeur comprise entre 5 et 6,5 GHz et une deuxième valeur comprise entre 8,5 et 10 GHz. De préférence, chacune des valeurs sélectionnables de fréquence est séparée des autres valeurs sélectionnables de fréquence par au moins 0,5 GHz. Toutefois, la personne du métier est en mesure, à partir des indications fonctionnelles données dans la présente description, de modifier la plage de fréquences à laquelle appartiennent les valeurs sélectionnables de fréquence et/ou les valeurs sélectionnables de fréquence. Par exemple, la personne du métier est en mesure, à partir de la présente description, d'adapter les valeurs sélectionnables de la capacité C de sorte que toute ou partie des fréquences de fonctionnement des oscillateurs du dispositif soient inférieures à 5 GHz. En effet, le dispositif décrit ici est adapté à fournir des signaux en quadrature à des fréquences inférieures à 5 GHz bien qu'il soit, par exemple, plus particulièrement avantageux pour des fréquences de fonctionnement supérieures à 5 GHz.

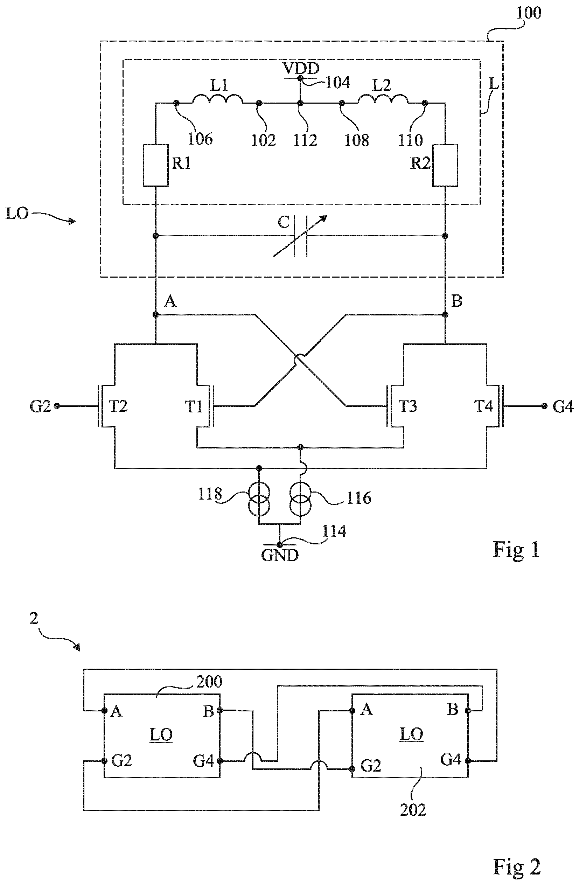

La figure 1 représente un mode de réalisation d'un oscillateur LO, et la figure 2 représente, sous la forme de blocs, un mode de réalisation d'un dispositif 2 comprenant deux oscillateurs LO en quadrature, c'est à dire interconnectés l'un à l'autre de sorte à fonctionner en quadrature ou, dit autrement, de sorte à fournir deux signaux en quadrature.

Comme cela se voit en figure 1, l'oscillateur LO comprend une charge 100 ("tank" en anglais) de type LC parallèle. La charge 100 comprend une capacité C et une inductance L. La capacité C à une valeur sélectionnable (commandable) parmi au moins deux valeurs correspondant chacune à une fréquence de fonctionnement des oscillateurs LO du dispositif 2.

Dans le dispositif 2, les deux oscillateurs LO en quadrature, référencés respectivement 200 et 202 en figure 2, sont configurés chacun de sorte que, pour chaque fréquence de fonctionnement des oscillateurs LO du dispositif 2, le facteur de qualité de l'inductance L de l'oscillateur soit inférieur à celui de sa capacité C.

Selon un mode de réalisation, pour obtenir cette relation entre les facteurs de qualité de l'inductance L et de la capacité commandable C de l'oscillateur LO, la capacité C est optimisée pour que son facteur de qualité soit aussi élevé que possible, et l'inductance L est choisie avec un faible facteur de qualité qui soit plus faible que celui de la capacité C.

Selon un mode de réalisation, l'inductance L comprend au moins une résistance. Cela permet de diminuer le facteur de qualité de l'inductance L par rapport au cas où la résistance est omise, de sorte que le facteur de qualité de l'inductance L soit inférieur à celui de la capacité C.

Dans chaque oscillateur LO, la charge 100 est connectée entre deux noeuds A et B de sortie de l'oscillateur LO. Par exemple, l'inductance L est connectée entre les deux noeuds A et B et la capacité C est connectée entre les deux noeuds A et B, en parallèle de l'inductance L. Plus particulièrement, la capacité C a une électrode connectée au noeud A et une électrode connectée au noeud B.

Bien que cela ne soit pas représenté en figure 1, la capacité C comprend, selon un mode de réalisation, une banque de capacités sélectionnables, c'est à dire plusieurs capacités et plusieurs interrupteurs associés à ces capacités et configurés pour que chaque valeur sélectionnable de la capacité C corresponde à une combinaison donnée des états ouvert et fermé de ces interrupteurs. Dans ce cas, les signaux de commande des interrupteurs sont des signaux de commande de la capacité C.

Selon un mode de réalisation, la capacité C comprend en outre des diodes varicap (varactors), une diode varicap étant une diode se comportant comme une capacité dont la valeur varie avec la tension inverse appliquée à ses bornes. Dans un tel mode de réalisation, la banque de capacité permet un réglage grossier de la valeur de la capacité C et les diodes varicaps permettent un réglage fin de la valeur de la capacité C. Dans ce cas, le ou les signaux permettant de sélectionner ou commander la valeur de la tension inverse appliquée aux bornes de chaque diode varicap sont, en plus des signaux de commande des interrupteurs de la banque de capacités, des signaux de commande de la capacité C.

La mise en œuvre de la capacité C est à la portée de la personne du métier à partir des indications fonctionnelles données dans la présente description.

Selon un mode de réalisation, l'inductance L de chaque oscillateur LO comprend un premier enroulement L1 et un deuxième enroulement L2 identique à l'enroulement L1. Les enroulements sont connectés en série entre les noeuds A et B de l'oscillateur LO. Plus particulièrement, l'enroulement L1 a une extrémité 102 couplée, de préférence connectée, à un noeud 112 lui-même couplé à un noeud 104 configuré pour recevoir un potentiel d'alimentation VDD, et une extrémité 106 couplée au noeud A, l'enroulement L2 ayant une extrémité 108 couplée, de préférence connectée, au noeud 112 et une extrémité 110 couplée au noeud B. Dans l'exemple de la figure 1, les extrémités 102 et 108 des enroulements respectifs L1 et L2 sont connectées au noeud 112. En outre, dans l'exemple de la figure 1, le noeud 112 est connecté au noeud 104.

Dans l'exemple de la figure 1, le potentiel VDD est positif et référencé par rapport à un potentiel de référence GND, par exemple la masse.

Dans un mode de réalisation non illustré l'inductance L est dépourvue de résistance et ne comprend que des enroulements, par exemple les enroulements L1 et L2. Dans un tel mode de réalisation, l'inductance L et la capacité C restent cependant configurées pour que, pour chacune des fréquences de fonctionnement du dispositif 2, le facteur de qualité de l'inductance L soit inférieur à celui de la capacité C.

Toutefois, en fonction du nombre et/ou des valeurs des fréquences de fonctionnement du dispositif 2, il est difficile voire impossible de disposer d'une inductance L dont le facteur de qualité est inférieur à celui de la capacité pour chaque fréquence de fonctionnement du dispositif 2.

Ainsi, selon un autre mode de réalisation, comme cela a été indiqué précédemment, l'inductance L comprend au moins une résistance de sorte à diminuer son facteur de qualité. Plus particulièrement, comme cela est illustré en figure 1, l'inductance L comprend une résistance R1 connectée en série avec l'enroulement L1 entre les noeuds 112 et A, et une résistance R2 connectée en série avec l'enroulement L2 entre les noeuds 112 et B. Les résistances R1 et R2 ont une même valeur de résistance, par exemple comprise entre 0,5 et 5 ohms. A titre d'exemple, comme cela est représenté en figure 1, la résistance R1 est connectée entre l'extrémité 106 de l'enroulement L1 et le noeud A, la résistance R2 étant connectée entre l'extrémité 110 de l'enroulement L2 et le noeud B.

Selon un mode de réalisation, chaque résistance R1, R2 est mise en œuvre par au moins une portion de silicium polycristallin non dopé, c'est à dire non dopé intentionnellement. Par exemple, dans chaque résistance R1, R2, chaque portion de silicium polycristallin de la résistance repose sur un substrat semiconducteur. A titre d'exemple, une couche isolante est disposée entre le silicium polycristallin et le substrat pour séparer le silicium polycristallin de la résistance du semiconducteur du substrat, bien que dans d'autres exemples cette couche isolante puisse être omise. Par exemple, dans chaque résistance R1, R2, chaque portion de silicium polycristallin de la résistance a une extrémité (ou un côté) couplée électriquement à une même portion de couche conductrice d'un niveau de métal d'une structure d'interconnexion reposant sur le substrat, cette portion conductrice correspondant, par exemple, à une première borne de la résistance, et une deuxième extrémité couplée électriquement à une même autre portion de couche conductrice de ce niveau de métal, cette autre portion conductrice correspondant, par exemple, à une deuxième borne de la résistance.

Dans des variantes de réalisation, les résistance R1 et R2 peuvent être mises en œuvre chacune par une portion de couche conductrice métallique d'un niveau de métal d'une structure d'interconnexion. Toutefois, cette portion de couche conductrice métallique sera sujette aux phénomènes d'électromigrations ce qui n'est pas le cas du silicium polycristallin.

Chaque oscillateur LO comprend en outre des transistors T1, T2, T3 et T4. Les transistors T1 à T4 sont des transistors MOS (de l'anglais "Metal Oxide Semiconductor" - métal oxyde semiconducteur).

Les transistors T1 et T2 ont chacun une première borne de conduction couplée, de préférence connectée, au noeud A, et une deuxième borne de conduction couplée à un noeud 114 configuré pour recevoir le potentiel de référence GND. Les transistors T3 et T4 ont chacun une première borne de conduction couplée, de préférence connectée, au noeud B, et une deuxième borne de conduction couplée au noeud 114. La première borne de conduction de chaque transistor T1, T2, T3, T4 correspond, par exemple, au drain de ce transistor, sa deuxième borne de conduction correspondant alors à sa source.

Le transistor T1 a sa grille couplée, par exemple connectée, au noeud B, le transistor T3 ayant sa grille couplée, par exemple connectée, au noeud A.

Dans la suite de la description, dans chaque oscillateur LO, la grille du transistor T2 est référencée G2 et la grille du transistor T4 est référencée G4. Dans chaque oscillateur LO, les noeuds A et B sont par exemple des sorties de l'oscillateur, et les bornes G2 et G4 sont des entrées de l'oscillateur.

L'interconnexion de deux oscillateurs en quadrature est, par exemple, illustrée par la figure numérotée 1(d) de l'article "A 900MHz CMOS LC-Oscillator with Quadrature Outputs", et s'applique aux deux oscillateurs 200 et 202 du dispositif 2.

Plus particulièrement, comme cela se voit en figure 2 où les oscillateurs LO 200 et 202 sont chacun représentés par un bloc comprenant deux sorties A et B et deux entrées G2 et G4, dans le dispositif 2 :
- l'entrée G2 de l'oscillateur 200 est couplée, par exemple connectée, à la sortie A de l'oscillateur 202 ;
- l'entrée G4 de l'oscillateur 200 est couplée, par exemple connectée, à la sortie B de l'oscillateur 202 ;
- l'entrée G2 de l'oscillateur 202 est couplée, par exemple connectée, à la sortie B de l'oscillateur 200 ; et
- l'entrée G4 de l'oscillateur 202 est couplée, par exemple connectée, à la sortie A de l'oscillateur 200.

Dans l'exemple de la figure 1 où le potentiel VDD est positif par rapport au potentiel GND, les transistors T1 à T4 sont des transistors MOS à canal N ou NMOS. Dans un autre exemple non illustré où le potentiel VDD est négatif par rapport au potentiel GND, les transistors T1 à T4 sont des transistors MOS à canal P, ou PMOS.

A titre d'exemple, les transistors T1 et T3 sont identiques l'un à l'autre, et les transistors T2 et T4 sont identiques l'un à l'autre.

Dans des exemples, tous les transistors T1 à T4 sont identiques, c'est à dire qu'ils ont les mêmes dimensions.

Dans d'autres exemples, le rapport entre les dimensions des transistors identiques T1 et T3 et celles des transistors identiques T2 et T4 est déterminé par un coefficient de couplage cible entre les deux oscillateurs 200 et 202.

Selon un mode de réalisation, le noeud 112 est connecté au noeud 104, les extrémités 102 et 108 des enroulements respectifs L1 et L2 étant alors, par exemple, connectées au noeud 104. En outre, les deuxièmes bornes de conduction des transistors T1 à T4 sont couplées au noeud 114 par au moins une source de courant. A titre d'exemple, dans un tel mode de réalisation, dans chaque oscillateur LO, la grille du transistor T1 est connectée au noeud B de l'oscillateur, la grille du transistor T3 étant connectée au noeud A de l'oscillateur. Toujours à titre d'exemple, dans un tel mode de réalisation, l'entrée G2 de l'oscillateur 200 est connectée à la sortie A de l'oscillateur 202, l'entrée G4 de l'oscillateur 200 est connectée à la sortie B de l'oscillateur 202, l'entrée G2 de l'oscillateur 202 est connectée à la sortie B de l'oscillateur 200, et l'entrée G4 de l'oscillateur 202 est connectée à la sortie A de l'oscillateur 200.

A titre d'exemple, dans un mode de réalisation où les deuxièmes bornes de conduction des transistors T1 à T4 sont couplées au noeud 114 par au moins une source de courant, comme cela est illustré en figure 1, dans chaque oscillateur LO, une source de courant 116 est connectée entre les deuxièmes bornes de conduction des transistors T1 et T3 et le noeud 114, et une autre source de courant 118 est connectée entre les deuxièmes bornes de conduction des transistors T2 et T4 et le noeud 114. La source de courant 116 a, par exemple, une borne connectée aux deuxièmes bornes de conduction des transistors T1 et T3 et une autre borne connectée au noeud 114, la source de courant 116 ayant, par exemple, une borne connectée aux deuxièmes bornes de conduction des transistors T2 et T4 et une autre borne connectée au noeud 114.

La prévision de deux sources de courant 116 et 118 pour polariser les transistors respectivement T1 et T3, et T2 et T4, permet que le paramètre gm des transistors T1 et T3 soit différent du paramètre gm des transistors T2 et T4.

A titre d'exemple alternatif non illustré, dans un mode de réalisation où les deuxièmes bornes de conduction des transistors T1 à T4 sont couplées au noeud 114 par au moins une source de courant, dans chaque oscillateur LO, une seule source de courant est connectée entre les deuxièmes bornes de conduction des transistors T1 à T4 et le noeud 114, cette source de courant ayant, par exemple, une borne connectée à la deuxième borne de conduction de chacun des transistors T1 à T4 et une autre borne de conduction connectée au noeud 114.

Dans une variante de réalisation non illustrée, les deuxièmes bornes de conduction des transistors T1 à T4 sont toutes connectées au noeud 114 et le noeud 112 est couplé au noeud 104 par une source de courant, la source de courant ayant, par exemple, une borne connectée au noeud 112 et une borne connectée au noeud 104. A titre d'exemple, dans une telle variante de réalisation, dans chaque oscillateur LO, la grille du transistor T1 est connectée au noeud B de l'oscillateur, la grille du transistor T3 étant connectée au noeud A de l'oscillateur. Toujours à titre d'exemple, dans une telle variante de réalisation, l'entrée G2 de l'oscillateur 200 est connectée à la sortie A de l'oscillateur 202, l'entrée G4 de l'oscillateur 200 est connectée à la sortie B de l'oscillateur 202, l'entrée G2 de l'oscillateur 202 est connectée à la sortie B de l'oscillateur 200, et l'entrée G4 de l'oscillateur 202 est connectée à la sortie A de l'oscillateur 200.

Dans une autre variante de réalisation non illustrée, les deuxièmes bornes de conduction des transistors T1 à T4 sont toutes connectées au noeud 114, et le noeud 112 est connecté au noeud 104. A titre d'exemple, dans une telle variante de réalisation, dans chaque oscillateur LO, la grille du transistor T1 est couplée au noeud B de l'oscillateur par une capacité, la grille du transistor T3 est couplée au noeud A de l'oscillateur par une capacité, l'entrée G2 de l'oscillateur 200 est couplée à la sortie A de l'oscillateur 202 par une capacité, l'entrée G4 de l'oscillateur 200 est couplée à la sortie B de l'oscillateur 202 par une capacité, l'entrée G2 de l'oscillateur 202 est couplée à la sortie B de l'oscillateur 200 par une capacité, et l'entrée G4 de l'oscillateur 202 est couplée à la sortie A de l'oscillateur 200 par une capacité.

Le dispositif 2 décrit ci-dessus permet d'obtenir un premier signal périodique sur la sortie B de l'oscillateur 200, un deuxième signal périodique sur la sortie A de l'oscillateur 200, le deuxième signal ayant la même fréquence que le premier signal mais étant déphasé de 180° par rapport au premier signal, un troisième signal périodique sur la sortie B de l'oscillateur 202, le troisième signal ayant la même fréquence que le premier signal mais étant déphasé de 90° par rapport au premier signal, et un quatrième signal périodique sur la sortie A de l'oscillateur 202, le quatrième signal ayant la même fréquence que le premier signal mais étant déphasé de 270° par rapport au premier signal. Ainsi, les signaux des sorties A et B de l'oscillateur 202 sont en quadrature avec les signaux des sorties respectives A et B de l'oscillateur 200.

A titre d'exemple, le dispositif 2 de la figure 2 permet de générer deux signaux périodiques en quadrature à une fréquence sélectionnable parmi cinq valeurs de fréquences égales respectivement à 6,4896 GHz ; 7,1136 GHz ; 7,7376 GHz ; 8,3616 GHz et 8,9856 GHz, en maintenant les oscillateurs dans le même mode de fonctionnement pour chacune de ces valeurs, ce qui n'était pas possible avec les dispositifs à oscillateurs en quadrature connus.

En reprenant l'exemple ci-dessus, la valeur des résistances R1 et R2 est, par exemple, comprise entre 0,5 et 5 ohms, la valeur de l'inductance L, c'est à dire de l'ensemble des deux enroulements L1 et L2, est, par exemple, comprise entre 300 et 700 pH (pico henry) et chacune des valeurs que peut prendre la capacité C est, par exemple, comprise entre 0,5 et 2 pF (pico farad).

La personne du métier sera en mesure, à partir de la description fonctionnelle faite ci-dessus, de prévoir d'autres valeurs de fréquence de fonctionnement, et d'adapter les valeurs de l'inductance L et la capacité variable C en conséquence.

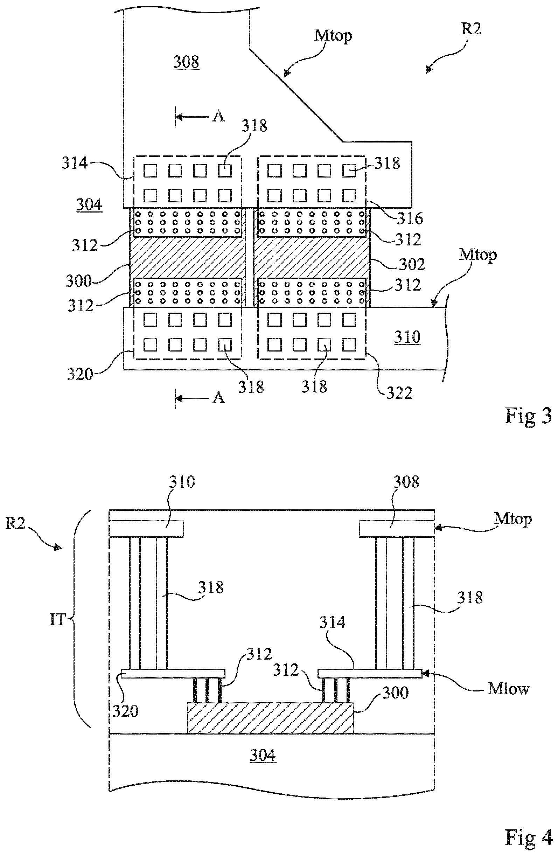

La figure 3 représente, par une vue de dessus schématique, un exemple d'un mode de réalisation des résistances R1 et R2 des oscillateurs des figures 1 et 2, la figure 4 étant une vue en coupe prise dans le plan AA de la figure 3. En figures 3 et 4, seule la résistance R2 est représentée étant entendu que la résistance R1 est identique ou similaire à la résistance R2. Dans ce mode de réalisation, la résistance R2 est mise en œuvre par au moins une portion de silicium polycristallin non dopé.

Par exemple, en figure 3 et 4, la résistance R2 est mise en œuvre par deux portions 300 et 302 de silicium polycristallin. La prévision de deux portions 300 et 302 de silicium polycristallin plutôt que d'une seule peut résulter par exemple de contraintes de dessins du circuit intégré dans une technologie de fabrication donnée. Toutefois, chaque résistance R1, R2 peut également être mise en œuvre par une unique portion de silicium polycristallin ou par plus de deux portions de silicium polycristallin.

Chaque portion 300, 302 de silicium polycristallin de la résistance R2 repose sur un substrat semiconducteur 304, par exemple en silicium monocristallin.

Dans l'exemple représenté, le silicium polycristallin des portions 300 et 302 repose directement sur le substrat 304.

Toutefois, dans d'autres exemples non illustrés, chaque portion 300, 302 est séparée du substrat 304 par une couche isolante disposée entre le silicium polycristallin et le substrat. A titre d'exemple, dans ce cas, la couche isolante a une première face en contact avec le substrat 304 et une deuxième face en contact avec le silicium polycristallin, la deuxième face étant opposée à la première face.

Chaque portion 300, 302 a une extrémité ou un côté (en haut en figure 3 et à droite en figure 4) qui est couplée électriquement à une même portion 308 d'une couche conductrice d'un niveau de métal Mtop d'une structure d'interconnexion IT reposant sur le substrat 304. Ainsi, dans l'exemple des figures 3 et 4 où la résistance R2 comprend deux portions 300 et 302 de silicium polycristallin, ces deux portions sont couplées électriquement à la portion 308 du niveau de métal Mtop. La portion 308 du niveau de métal Mtop correspond, par exemple, à une première borne de la résistance R2, par exemple connectée à l'extrémité 110 de l'enroulement L2 de l'inductance L (figure 1).

De manière symétrique, chaque portion 300, 302 a une autre extrémité ou un autre côté (en bas en figure 3 et à gauche en figure 4) qui est couplée électriquement à une même portion 310 d'une couche conductrice du niveau de métal Mtop. Ainsi, dans l'exemple des figures 3 et 4 où la résistance R2 comprend deux portions 300 et 302 de silicium polycristallin, ces deux portions sont couplées électriquement à la portion 310 du niveau de métal Mtop. La portion 310 du niveau de métal Mtop correspond, par exemple, à une deuxième borne de la résistance R2, par exemple connectée au noeud B (figure 1).

A titre d'exemple, chaque portion 300, 302 est couplée électriquement à la portion 308, respectivement 310, du niveau de métal Mtop par l'intermédiaire de vias conducteurs et, par exemple, d'une ou plusieurs portions de couches conductrices d'un ou plusieurs niveaux de métal de la structure IT qui sont disposés entre le silicium polycristallin et le niveau de métal Mtop.

De préférence, le niveau Mtop correspond au niveau de métal le moins résistif de la structure IT, c'est à dire, par exemple, au niveau de métal qui est le plus éloigné du substrat.

Dans l'exemple des figures 3 et 4, une extrémité de de chacune des portions 300 et 302 (en haut en figure 3 et à droite en figure 4) est couplée par des vias conducteurs 312 à une portion correspondante 314, 316 d'un niveau de métal Mlow de la structure IT, cette portion 314, 316 étant couplée par des vias conducteurs 318 à la portion 308 du niveau de métal Mtop. Le niveau de métal Mlow est disposé entre le substrat 304 et le niveau de métal Mtop. En outre, une autre extrémité de chacune des portions 300 et 302 (en bas en figure 3 et à gauche en figure 4) est couplée par d'autres vias conducteurs 312 à une portion correspondante 320, 322 du niveau de métal Mlow, cette portion 320, 322 étant couplée par des vias conducteurs 318 à la portion 310 du niveau de métal Mtop.

De préférence, le niveau de métal Mlow est le niveau de métal de la structure IT le moins résistif à partir duquel des vias 312 peuvent s'étendre jusqu'au silicium polycristallin de la résistance, c'est à dire le silicium polycristallin des portions 300 et 302 dans cet exemple. Dit autrement, de préférence, le niveau de métal Mlow est le niveau de métal le moins résistif parmi tous les niveaux de métal de la structure IT à partir desquels des vias peuvent être formés jusqu'au silicium polycristallin de la résistance.

Par ailleurs, bien que cela ne soit pas détaillé en figures 3 et 4, la structure d'interconnexion IT comprend généralement des niveaux de métal intermédiaires disposés entre le niveau Mtop et le niveau Mlow. Bien que cela ne soit pas détaillé en figures 3 et 4, un ou plusieurs niveaux de métal peuvent être prévus entre le niveau Mlow et le substrat.

A titre d'exemple, comme cela est illustré en figures 3 et 4, des vias 312 s'étendent depuis une extrémité de la portion 300 jusqu'à la portion 314 du niveau de métal Mlow, d'autres vias 312 s'étendent depuis une autre extrémité de la portion 300 jusqu'à la portion 320 du niveau de métal Mlow, encore d'autres vias 312 s'étendent depuis une extrémité de la portion 302 jusqu'à la portion 316 du niveau de métal Mlow et encore d'autres vias 312 s'étendent depuis une autre extrémité de la portion 302 jusqu'à la portion 322 du niveau de métal Mlow. En outre, des vias 318 s'étendent depuis chacune des portions 314 et 316 du niveau de métal Mlow jusqu'à la portion 308 du niveau de métal Mtop, et d'autres vias 318 s'étendent depuis chacune des portions 320 et 322 du niveau de métal Mlow jusqu'à la portion 310 du niveau de métal Mtop.

Un avantage de prévoir un couplage des portions 300 et 302 avec le niveau de métal Mtop par l'intermédiaire des vias 318, du niveau de métal Mlow et des vias 312 est que la densité d'intégration des vias 312 est plus importante que celle des vias 318, ce qui permet de réduire la résistance de la connexion électrique entre le niveau de métal Mtop et le silicium polycristallin.

Bien que dans l'exemple ci-dessus, la portion 300 de silicium polycristallin soit couplée par des vias 112 à des portions 314 et 320 du niveau de métal Mlow et que la portion 302 de silicium polycristallin soit couplée par des vias 112 à des portions 316 et 322 distinctes des portions respectives 314 et 320, ce choix est par exemple lié à des règles de dessins du circuit intégré. Ainsi, dans d'autres exemples non illustrés, la portion 314 et la portion 318 du niveau de métal Mlow forment une seule et même portion de ce niveau de métal, et, de manière similaire, la portion 314 et la portion 318 du niveau de métal Mlow forment une seule et même portion de ce niveau de métal.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif (200) comprenant deux oscillateurs (LO ; 200, 202) couplés l'un à l'autre de sorte à fonctionner en quadrature, chaque oscillateur comprenant une inductance (L) et une capacité (C) à valeur sélectionnable parmi au moins deux valeurs correspondant chacune à une valeur de fréquence de fonctionnement des oscillateurs,
**caractérisé en ce que** chaque oscillateur est configuré pour que, pour chaque valeur de fréquence de fonctionnement des oscillateurs, le facteur de qualité de son inductance (L) soit inférieur au facteur de qualité de sa capacité (C).

2. Dispositif selon la revendication 1 dans lequel, dans chaque oscillateur :
l'inductance (L) comprend des premier et deuxième enroulements (L1, L2) identiques ;
le premier enroulement (L1) a une première extrémité (102) couplée à un premier noeud (104) d'application d'un potentiel d'alimentation (VDD) et une deuxième extrémité (106) couplée à un deuxième noeud (A) de sortie de l'oscillateur ;
le deuxième enroulement (L2) a une première extrémité (108) couplée au premier noeud (104) et une deuxième extrémité (110) couplée à un troisième noeud (B) de sortie de l'oscillateur ; et
une première électrode de la capacité (C) est connectée au deuxième noeud (A) et une deuxième électrode de la capacité est connectée au troisième noeud (B).

3. Dispositif selon la revendication 2, dans lequel, dans chaque oscillateur (200, 202), l'inductance (L) comprend une première résistance (R1) connectée en série avec le premier enroulement (L1) entre les premier et deuxième noeuds (104, A), et une deuxième résistance (R2) connectée en série avec le deuxième enroulement (L2) entre les premier et troisième noeuds (104, B), les première et deuxième résistances (R1, R2) ayant une même valeur de résistance.

4. Dispositif selon la revendication 3, dans lequel chacune des première et deuxième résistances (R1, R2) a une valeur de résistance comprise entre 0,5 et 5 ohms, lesdites au moins deux valeurs de la capacité (C) étant par exemple comprises entre 0,5 et 2,0 pF et l'inductance (L) ayant par exemple une valeur comprise entre 300 et 700 pH.

5. Dispositif selon la revendication 3 ou 4, dans lequel, dans chaque oscillateur (200, 202), chacune des première et deuxième résistances (R1, R2) est mise en œuvre par au moins une portion de silicium polycristallin (300, 302), de préférence non dopé.

6. Dispositif selon la revendication 5, dans lequel chacune des première et deuxième résistances (R1, R2) comprend :
une première portion conductrice (308) d'un premier niveau de métal (Mtop) d'une structure d'interconnexion (IT), la première portion conductrice (308) correspondant à une première borne de la résistance ;
une deuxième portion conductrice (310) du premier niveau de métal (Mtop) correspondant à une deuxième borne de la résistance ;
au moins une troisième portion conductrice (314, 316) d'un deuxième niveau de métal (Mlow) de la structure d'interconnexion (IT) ;
au moins une quatrième portion conductrice (320, 322) du deuxième niveau de métal (Mlow) ;
des premiers vias conducteurs (318) couplant électriquement la première portion (308) à ladite au moins une troisième portion (314, 316) et la deuxième portion (310) à ladite au moins une quatrième portion (320, 322) ; et
des deuxièmes vias conducteurs (312) couplant électriquement ladite au moins une portion de silicium polycristallin (300, 302) à ladite au moins une troisième portion (314, 316) et à ladite au moins une quatrième portion (320, 322).

7. Dispositif selon l'une quelconque des revendications 2 à 6, dans lequel, dans chacun des oscillateurs (200, 202), la capacité (C) comprend une pluralité de capacités associées à des interrupteurs configurés pour que chacune des au moins deux valeurs corresponde à une combinaison donnée d'états ouvert et fermé desdits interrupteurs.

8. Dispositif selon la revendication 7, dans lequel, dans chacun des oscillateurs (200, 202), la capacité à valeur sélectionnable comprend en outre des diodes varicap.

9. Dispositif selon l'une quelconque des revendications 2 à 8, dans lequel chacun des oscillateurs comprend en outre :
un premier transistor MOS (T1) et un deuxième transistor MOS (T2) ayant chacun une première borne de conduction connectée au deuxième noeud (A) et une deuxième borne de conduction couplée à un cinquième noeud (114) d'application d'un potentiel de référence (GND), le premier transistor (T1) ayant sa grille couplée au troisième noeud (B) ;
un troisième transistor MOS (T3) et un quatrième transistor MOS (T4) ayant chacun une première borne de conduction connectée au troisième noeud (B) et une deuxième borne de conduction couplée au cinquième noeud (114), le troisième transistor (T3) ayant sa grille couplée au deuxième noeud (A).

10. Dispositif selon la revendication 9, dans lequel :
le deuxième transistor (T2) d'un premier (200) des deux oscillateurs (200, 202) a sa grille couplée au deuxième noeud (A) d'un deuxième (202) des deux oscillateurs (200, 202) ;
le quatrième transistor (T4) du premier oscillateur (200) a sa grille couplée au troisième noeud (B) du deuxième oscillateur (202) ;
le deuxième transistor (T2) du deuxième oscillateur (202) a sa grille couplée au troisième noeud (B) du premier oscillateur (200) ; et
le quatrième transistor (T4) du deuxième oscillateur (202) a sa grille couplée au deuxième noeud (A) du premier oscillateur (200).

11. Dispositif selon la revendication 9 ou 10, dans lequel chacun des oscillateurs comprend :
une première source de courant (116) ayant une première borne connectée aux deuxièmes bornes de conduction des premier et troisième transistors (T1, T3) de l'oscillateur, et une deuxième borne connectée au cinquième noeud (114) ; et
une deuxième source de courant (118) ayant une première borne connectée aux deuxièmes bornes de conduction des deuxième et quatrième transistors (T2, T4) de l'oscillateur, et une deuxième borne connectée au cinquième noeud (114).

12. Dispositif selon l'une quelconque des revendications 1 à 11, dans lequel chaque valeur de fréquence de fonctionnement appartient à une plage allant de 5 GHz à 10 GHz.

13. Dispositif selon l'une quelconque des revendications 1 à 12, dans lequel les valeurs de fréquence de fonctionnement comprennent une première valeur comprise entre 5 et 6,5 GHz et une deuxième valeur comprise entre 8,5 et 10 GHz.

14. Dispositif selon l'une quelconque des revendications 1 à 13, dans lequel chacune des valeurs de fréquence de fonctionnement est séparée des autres valeurs de fréquence de fonctionnement par au moins 0,5 GHz.

## Patentansprüche

1. Einrichtung (200), die zwei Oszillatoren (LO; 200, 202) aufweist, die miteinander gekoppelt sind, um in Quadratur zu arbeiten, wobei jeder Oszillator eine Induktivität (L) und ein kapazitives Element (C) mit einem Wert aufweist, der aus wenigstens zwei Werten auswählbar ist, von denen jeder einem Betriebsfrequenzwert der Oszillatoren entspricht, **dadurch gekennzeichnet, dass** jeder Oszillator so konfiguriert ist, dass für jeden Betriebsfrequenzwert der Oszillatoren der Qualitätsfaktor seiner Induktivität (L) niedriger als der Qualitätsfaktor seines kapazitiven Elements (C) ist.

2. Einrichtung nach Anspruch 1, wobei in jedem Oszillator:
die Induktivität (L) erste und zweite identische Wicklungen (L1, L2) aufweist;
die erste Wicklung (L1) ein erstes Ende (102) hat, das mit einem ersten Knoten (104) zum Anlegen eines Versorgungspotentials (VDD) gekoppelt ist, und ein zweites Ende (106), das mit einem zweiten Ausgangsknoten (A) des Oszillators gekoppelt ist;
die zweite Wicklung (L2) ein erstes Ende (108) hat, das mit dem ersten Knoten (104) gekoppelt ist, und ein zweites Ende (110), das mit einem dritten Ausgangsknoten (B) des Oszillators gekoppelt ist; und
eine erste Elektrode des kapazitiven Elements (C) mit dem zweiten Knoten (A) verbunden ist und eine zweite Elektrode des kapazitiven Elements mit dem dritten Knoten (B) verbunden ist.

3. Einrichtung nach Anspruch 2, wobei in jedem Oszillator (200, 202) die Induktivität (L) einen ersten Widerstand (R1) aufweist, der in Reihe mit der ersten Wicklung (L1) zwischen dem ersten und dem zweiten Knoten (104, A) geschaltet ist, und einen zweiten Widerstand (R2), der in Reihe mit der zweiten Wicklung (L2) zwischen dem ersten und dem dritten Knoten (104, B) geschaltet ist, wobei der erste und der zweite Widerstand (R1, R2) einen gleichen Widerstandswert haben.

4. Einrichtung nach Anspruch 3, wobei jeder des ersten und des zweiten Widerstands (R1, R2) einen Widerstandswert im Bereich von 0,5 bis 5 Ohm hat, wobei die wenigstens zwei Werte der Kapazität (C) beispielsweise im Bereich von 0,5 bis 2,0 pF liegen und die Induktivität (L) beispielsweise einen Wert im Bereich von 300 bis 700 pH hat.

5. Einrichtung nach Anspruch 3 oder 4, wobei in jedem Oszillator (200, 202) jeder des ersten und des zweiten Widerstands (R1, R2) durch wenigstens einen Polysiliziumabschnitt (300, 302), vorzugsweise undotiert, ausgebildet ist.

6. Einrichtung nach Anspruch 5, wobei jeder des ersten und des zweiten Widerstands (R1, R2) Folgendes aufweist:
einen ersten leitfähigen Abschnitt (308) einer ersten Metallebene (Mtop) einer Verbindungsstruktur (IT), wobei der erste leitfähige Abschnitt (308) einem ersten Anschluss des Widerstands entspricht;
einen zweiten leitfähigen Abschnitt (310) der ersten Metallebene (Mtop), der einem zweiten Anschluss des Widerstands entspricht;
wenigstens einen dritten leitfähigen Abschnitt (314, 316) einer zweiten Metallebene (Mlow) der Verbindungsstruktur (IT);
wenigstens einen vierten leitfähigen Abschnitt (320, 322) der zweiten Metallebene (Mlow);
erste leitfähige Durchkontaktierungen (318), die den ersten Abschnitt (308) mit dem wenigstens einen dritten Abschnitt (314, 316) und den zweiten Abschnitt (310) mit dem wenigstens einen vierten Abschnitt (320, 322) elektrisch koppeln; und
zweite leitfähige Durchkontaktierungen (312), die den wenigstens einen Polysiliziumabschnitt (300, 302) mit dem wenigstens einen dritten Abschnitt (314, 316) und mit dem wenigstens einen vierten Abschnitt (320, 322) elektrisch koppeln.

7. Einrichtung nach einem der Ansprüche 2 bis 6, wobei in jedem der Oszillatoren (200, 202) das kapazitive Element (C) eine Vielzahl von kapazitiven Elementen aufweist, die mit Schaltern assoziiert sind, die so konfiguriert sind, dass jeder der wenigstens zwei Werte einer gegebenen Kombination von Aus- und Ein-Zuständen der Schalter entspricht.

8. Einrichtung nach Anspruch 7, wobei in jedem der Oszillatoren (200, 202) das kapazitive Element mit auswählbarem Wert ferner Varaktordioden aufweist.

9. Einrichtung nach einem der Ansprüche 2 bis 8, wobei jeder der Oszillatoren ferner Folgendes aufweist:
einen ersten MOS-Transistor (T1) und einen zweiten MOS-Transistor (T2), von denen jeder einen ersten Leitungsanschluss hat, der mit dem zweiten Knoten (A) verbunden ist, und einen zweiten Leitungsanschluss, der mit einem fünften Knoten (114) zum Anlegen eines Referenzpotentials (GND) gekoppelt ist, wobei der erste Transistor (T1) sein Gate mit dem dritten Knoten (B) gekoppelt hat;
einen dritten MOS-Transistor (T3) und einen vierten MOS-Transistor (T4), von denen jeder einen ersten Leitungsanschluss hat, der mit dem dritten Knoten (B) verbunden ist, und einen zweiten Leitungsanschluss, der mit dem fünften Knoten (114) gekoppelt ist, wobei der dritte Transistor (T3) sein Gate mit dem zweiten Knoten (A) gekoppelt hat.

10. Einrichtung nach Anspruch 9, wobei:
der zweite Transistor (T2) eines ersten (200) der zwei Oszillatoren (200, 202) sein Gate mit dem zweiten Knoten (A) eines zweiten (202) der zwei Oszillatoren (200, 202) gekoppelt hat;
der vierte Transistor (T4) des ersten Oszillators (200) sein Gate mit dem dritten Knoten (B) des zweiten Oszillators (202) gekoppelt hat;
der zweite Transistor (T2) des zweiten Oszillators (202) sein Gate mit dem dritten Knoten (B) des ersten Oszillators (200) gekoppelt hat; und
der vierte Transistor (T4) des zweiten Oszillators (202) sein Gate mit dem zweiten Knoten (A) des ersten Oszillators (200) gekoppelt hat.

11. Einrichtung nach Anspruch 9 oder 10, wobei jeder der Oszillatoren Folgendes aufweist:
eine erste Stromquelle (116) mit einem ersten Anschluss, der mit den zweiten Leitungsanschlüssen des ersten und des dritten Transistors (T1, T3) des Oszillators verbunden ist, und einem zweiten Anschluss, der mit dem fünften Knoten (114) verbunden ist; und
eine zweite Stromquelle (118) mit einem ersten Anschluss, der mit den zweiten Leitungsanschlüssen des zweiten und des vierten Transistors (T2, T4) des Oszillators verbunden ist, und einem zweiten Anschluss, der mit dem fünften Knoten (114) verbunden ist.

12. Einrichtung nach einem der Ansprüche 1 bis 11, wobei jeder Betriebsfrequenzwert zu einem Bereich von 5 GHz bis 10 GHz gehört.

13. Einrichtung nach einem der Ansprüche 1 bis 12, wobei die Betriebsfrequenzwerte einen ersten Wert im Bereich von 5 bis 6,5 GHz und einen zweiten Wert im Bereich von 8,5 bis 10 GHz aufweisen.

14. Einrichtung nach einem der Ansprüche 1 bis 13, wobei jeder der Betriebsfrequenzwerte von den anderen Betriebsfrequenzwerten um wenigstens 0,5 GHz getrennt ist.

## Claims

1. Device (200) comprising two oscillators (LO; 200, 202) coupled to each other so as to operate in quadrature, each oscillator comprising an inductance (L) and a capacitive element (C) having a value selectable from among at least two values, each corresponding to an operating frequency value of the oscillators, **characterized in that** each oscillator is configured so that, for each operating frequency value of the oscillators, the quality factor of its inductance (L) is lower than the quality factor of its capacitive element (C).

2. Device according to claim 1 wherein, in each oscillator:
the inductance (L) comprises first and second identical windings (L1, L2);
the first winding (L1) has a first end (102) coupled to a first node (104) of application of a power supply potential (VDD) and a second end (106) coupled to a second output node (A) of the oscillator;
the second winding (L2) has a first end (108) coupled to the first node (104) and a second end (110) coupled to a third output node (B) of the oscillator; and
a first electrode of the capacitive element (C) is connected to the second node (A) and a second electrode of the capacitive element is connected to the third node (B).

3. Device according to claim 2, wherein, in each oscillator (200, 202), the inductance (L) comprises a first resistor (R1) series-connected to the first winding (L1) between the first and second nodes (104, A), and a second resistor (R2) series-connected to the second winding (L2) between the first and third nodes (104, B), the first and second resistors (R1, R2) having a same resistance value.

4. Device according to claim 3, wherein each of the first and second resistors (R1, R2) has a resistance value in the range from 0.5 to 5 ohms, said at least two values of the capacitance (C) being for example in the range from 0.5 to 2.0 pF and the inductance (L) for example having a value in the range from 300 to 700 pH.

5. Device according to claim 3 or 4, wherein, in each oscillator (200, 202), each of the first and second resistors (R1, R2) is implemented by at least one polysilicon portion (300, 302), preferably non-doped.

6. Device according to claim 5, wherein each of the first and second resistors (R1, R2) comprises:
a first conductive portion (308) of a first metal level (Mtop) of an interconnection structure (IT), the first conductive portion (308) corresponding to a first terminal of the resistor;
a second conductive portion (310) of the first metal level (Mtop) corresponding to a second terminal of the resistor;
at least one third conductive portion (314, 316) of a second metal level (Mlow) of the interconnection structure (IT);
at least one fourth conductive portion (320, 322) of the second metal level (Mlow);
first conductive vias (318) electrically coupling the first portion (308) to said at least one third portion (314, 316) and the second portion (310) to said at least one fourth portion (320, 322); and
second conductive vias (312) electrically coupling said at least one polysilicon portion (300, 302) to said at least one third portion (314, 316) and to said at least one fourth portion (320, 322).

7. Device according to any of claims 2 to 6, wherein, in each of the oscillators (200, 202), the capacitive element (C) comprises a plurality of capacitive elements associated with switches configured so that each of the at least two values corresponds to a given combination of off and on states of said switches.

8. Device according to claim 7, wherein, in each of the oscillators (200, 202), the capacitive element with a selectable value further comprises varicap diodes.

9. Device according to any of claims 2 to 8, wherein each of the oscillators further comprises:
a first MOS transistor (T1) and a second MOS transistor (T2) each having a first conduction terminal connected to the second node (A) and a second conduction terminal coupled to a fifth node (114) of application of a reference potential (GND), the first transistor (T1) having its gate coupled to the third node (B);
a third MOS transistor (T3) and a fourth MOS transistor (T4) each having a first conduction terminal connected to the third node (B) and a second conduction terminal coupled to the fifth node (114), the third transistor (T3) having its gate coupled to the second node (A).

10. Device according to claim 9, wherein:
the second transistor (T2) of a first one (200) of the two oscillators (200, 202) has its gate coupled to the second node (A) of a second one (202) of the two oscillators (200, 202);
the fourth transistor (T4) of the first oscillator (200) has its gate coupled to the third node (B) of the second oscillator (202);
the second transistor (T2) of the second oscillator (202) has its gate coupled to the third node (B) of the first oscillator (200); and
the fourth transistor (T4) of the second oscillator (202) has its gate coupled to the second node (A) of the first oscillator (200).

11. Device according to claim 9 or 10, wherein each of the oscillators comprises:
a first current source (116) having a first terminal connected to the second conduction terminals of the first and third transistors (T1, T3) of the oscillator, and a second terminal connected to the fifth node (114); and
a second current source (118) having a first terminal connected to the second conduction terminals of the second and fourth transistors (T2, T4) of the oscillator, and a second terminal connected to the fifth node (114).

12. Device according to any of claims 1 to 11, wherein each operating frequency value belongs to a range from 5 GHz to 10 GHz.

13. Device according to any of claims 1 to 12, wherein the operating frequency values comprise a first value in the range from 5 to 6.5 GHz and a second value in the range from 8.5 to 10 GHz.

14. Device according to any of claims 1 to 13, wherein each of the operating frequency values is separated from the other operating frequency values by at least 0.5 GHz.
